# EUROPÄISCHE PATENTSCHRIFT

(11) **EP 0 866 150 B1**
(45) Veröffentlichungstag und Bekanntmachung des Hinweises auf die Patenterteilung: **13.06.2001**
(21) Anmeldenummer: 98104987.7
(22) Anmeldetag: 19.03.1998
(51) Int. Cl.: C30B 15/14, C30B 15/00, C30B 29/06

(54) **Vorrichtung und Verfahren zum Ziehen eines Einkristalls**
Apparatus and process for pulling a single crystal
Appareillage et procédé pour le tirage d'un monocristal

(30) Priorität: 21.03.1997 DE 19711922
(43) Veröffentlichungstag der Anmeldung: 23.09.1998
(73) Patentinhaber: Wacker Siltronic Gesellschaft für Halbleitermaterialien Aktiengesellschaft, 84489 Burghausen (DE)
(72) Erfinder: von Ammon, Wilfried, Dr., 84489 Burghausen (DE); Dornberger, Erich, 84489 Burghausen (DE); Ölkrug, Hans, Dr., 84529 Tittmoning (DE); Segieth, Franz, 94148 Kirchham (DE)

(56) Entgegenhaltungen:
- WO-A-92/18672
- DE-A- 3 905 626
- DE-A- 4 414 947
- FR-A- 1 316 707
- GB-A- 2 182 262
- VON AMMON ET AL.: "The dependence of bulk defects on the axial temperature gradient of silicon crystals during the Czochralski process" JOURNAL OF CRYSTAL GROWTH., Bd. 15, Nr. 3/4, 1.Juni 1995, AMSTERDAM NL, Seiten 273-277, XP000514096
- DORNBERGER ET AL.: "The dependence of ring like distributed stacking faults on the axial temeperature gradient of growing czochralski silicon crystals" JOURNAL OF THE ELECTROCHEMICAL SOCIETY., Bd. 143, Nr. 5, Mai 1996, MANCHESTER, NEW HAMPSHIRE US, Seiten 1648-1653, XP002066785

## Beschreibung

Gegenstand der Erfindung ist ein Verfahren zum Ziehen eines Einkristalls aus Silicium, bei dem der Einkristall mit einer Ziehgeschwindigkeit V unter Berücksichtigung des Quotienten V/G gezogen wird, wobei G der axiale Temperaturgradient im Bereich der Kristallisationsgrenze ist.

Es ist beispielsweise in der DE-4414947 A1 beschrieben, daß Halbleiterscheiben aus Silicium, die von einem Einkristall abgetrennt wurden, einen sogenannten Stapelfehlerkranz aufweisen können. Das Auftreten eines Stapelfehlerkranzes steht in engem Zusammenhang mit der Ziehgeschwindigkeit V und dem axialen Temperaturgradienten G im Bereich der Kristallisationsgrenze. Gemäß der empirisch gefundenen Formel V/G = 1,3 * 10⁻³ cm²min⁻¹K⁻¹ läßt sich eine untere Ziehgeschwindigkeit angeben, bei deren Überschreiten ein Stapelfehlerkranz gerade aufzutreten beginnt.

Im Stand der Technik ist ferner beschrieben, daß der Stapelfehlerkranz Gebiete der Halbleiterscheibe trennt, die durch das Vorhandensein unterschiedlicher Defekttypen und Defektdichten charakterisiert sind (E.Dornberger und W.v.Ammon, Journal Of The Electrochemical Society, Vol.143, No.5, 1996). Dieser Literaturstelle ist auch zu entnehmen, daß der axiale Temperaturgradient bei den üblicherweise praktizierten Ziehverfahren im Bereich der Kristallisationsgrenze nicht konstant ist, sondern sich, von der Kristallachse aus betrachtet, in radialer Richtung ändert.

In der WO-92/18672 sind Vorrichtungen zum Ziehen von Kristallen offenbart, mit denen die Temperatur der Oberfläche einer Schmelze beeinflusst werden kann.

Die FR-1.316.707 zeigt einen, den Kristall umgebenden Schild mit einem unteren Ende, das Strahlungswärme von der Schmelze zur Kristallisationsgrenze reflektieren kann.

In der GB-2 182 262 A ist eine Vorrichtung zum Ziehen von Siliciumkristallen offenbart, mit deren Hilfe Siliciumsubstrate mit einem hohen Sauerstoffgehalt erhalten werden können.

Gegenstand der DE-3905626 A1 ist ein Verfahren und eine Vorrichtung zur Züchtung von Siliciumkristallen, wobei bei der Züchtung darauf geachtet wird, daß die Verweilzeit des Siliciumkristalls in einem bestimmten Temperaturbereich nicht länger als eine bestimmte Zeitspanne beträgt.

Aufgabe der vorliegenden Erfindung ist es, eine Änderung des axialen Temperaturgradienten im Bereich der Kristallisationsgrenze in radialer Richtung weitgehend zu vermeiden.

Diese Aufgabe wird gelöst durch ein Verfahren gemäß Anpruch 1.

Die mit Hilfe der Erfindung erzielbare Vergleichmäßigung des axialen Temperaturgradienten G im Bereich der Kristallisationsgrenze ermöglicht die Herstellung von Halbleiterscheiben mit definiert einstellbarer Defektcharakteristik.

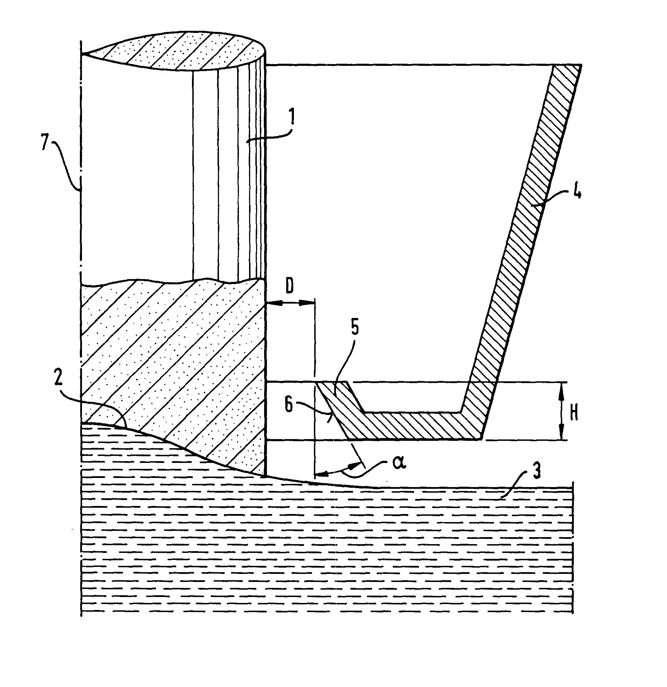

Die Erfindung wird nachfolgend an Hand einer Figur näher beschrieben. Es sind nur solche Merkmale dargestellt, die zum Verständnis der Erfindung beitragen. Die Figur zeigt schematisch die Ansicht eines Längsschnitts durch einen wachsenden Einkristall. Wegen der Achsensymmetrie ist nur die rechte Hälfte dargestellt.

Der Einkristall 1 wächst an einer Kristallisationsgrenze 2. Das zum Wachsen benötigte Material wird von einer Schmelze 3 geliefert. Um den Einkristall herum ist ein an sich bekannter Hitzeschild 4 angeordnet. Dieser ist im Bereich der Kristallisationsgrenze mit einem Element 5 verbunden, das bis zu einem Abstand D an den Einkristall heranreicht. Der Abstand D beträgt vorzugsweise 10 bis 50 mm. Das Element 5 weist eine dem Einkristall 1 gegenüberliegende Fläche 6 auf, die mit einem zwischen der Vertikalen und der Fläche bestehenden Winkel α zur Kristallisationsgrenze geneigt ist. Die Fläche erstreckt sich in Ziehrichtung über eine Höhe H. Die Höhe H beträgt vorzugsweise 25 bis 100 mm. Der Winkel α beträgt vorzugsweise maximal 60°. Die Fläche muß nicht notwendigerweise eben sein, sondern kann beispielsweise auch konkav oder konvex ausgebildet sein.

Das Element 5 ist im wesentlichen in Höhe der Kristallisationsgrenze 2 angeordnet, so daß der Bereich der Kristallisationsgrenze mit Hilfe des Elements thermisch beeinflußt werden kann. Zum Bereich der Kristallisationsgrenze wird im Sinne der Erfindung die Kristallisationsgrenze 2 und ein bis zu 2 mm in den Einkristall reichender Bereich gerechnet.

Um eine Vergleichmäßigung des axialen Temperaturgradienten in radialer Richtung mit Hilfe des Elements erreichen zu können, muß dieses vom Einkristall abgestrahlte Wärmestrahlung gut reflektieren oder in der Lage sein, den Einkristall mit Wärme zu beaufschlagen. Im ersten Fall besteht das Element 5 oder zumindest seine Fläche 6 aus einem Material mit hoher Reflektionswirkung für Wärmestrahlung, beispielsweise aus Molybdän oder poliertem Graphit. Im zweiten Fall ist das Element 5 als Heizelement, vorzugsweise als Widerstandsheizung ausgebildet. Zur weiteren Verbesserung der radialen Homogenität von G kann oberhalb des Elements aktiv gekühlt werden, beispielsweise indem oberhalb des Elements eine Einrichtung zur aktiven Kühlung vorgesehen wird, wie sie beispielsweise in der US-5,567,399 beschrieben ist.

## Patentansprüche

1. Verfahren zum Ziehen eines Einkristalls 1 aus Silicium, bei dem der Einkristall mit einer Ziehgeschwindigkeit V unter Berücksichtigung des Quotienten V/G gezogen wird, wobei G der axiale Temperaturgradient im Einkristall im Bereich einer Kristallisationsgrenze 2 ist, dadurch gekennzeichnet, die Geschwindigkeit V so gewählt wird, daß der Quotient V/G den Wert 1,3 * 10⁻³ cm²min⁻¹K⁻¹ ± 10% annimmt, und der Einkristall von einem Hitzeschild und im Bereich der Kristallisationsgrenze von einem Element 5 umgeben wird, das eine Höhe H mit einer Länge von 25 bis 100 mm und eine Fläche mit der Eigenschaft aufweist, vom Einkristall abgestrahlte Wärmestrahlung zur Kristallisationsgrenze zu reflektieren oder Wärmestrahlung zur Kristallisationsgrenze abzustrahlen, wobei eine Änderung des Quotienten V/G in radialer Richtung durch die Anordnung des Hitzeschilds und des Elements weitgehend vermieden wird.

## Claims

1. Method for pulling a silicon single crystal 1, in which the single crystal is pulled at a pull rate V while taking account of the ratio V/G, where G is the axial temperature gradient in the single crystal in the region of a crystallization boundary 2, characterized in that the rate V is selected in such a way that the ratio V/G takes the value 1.3 * 10⁻³ cm²min⁻¹K⁻¹ ± 10%, and the single crystal is surrounded by a heat shield and, in the region of the crystallization boundary, by an element 5, which has a height H with a length of 25 to 100 mm and a face having the property of reflecting heat radiation radiated by the single crystal to the crystallization boundary or of radiating heat radiation to the crystallization boundary, a change in the ratio V/G in the radial direction largely being avoided by virtue of the arrangement of the heat shield and of the element.

## Revendications

1. Procédé de tirage d'un monocristal 1 de silicium, dans lequel le monocristal est tiré à une vitesse de tirage V en tenant compte du quotient V/G, où G est le gradient de température axial dans le monocristal dans la zone d'une limite de cristallisation 2, caractérisé en ce que la vitesse V est choisie de telle sorte que le quotient V/G prenne la valeur de 1,3*10⁻³ cm²min⁻¹K⁻¹ ± 10%, et le monocristal est entouré d'un bouclier thermique et, dans la zone de la limite de cristallisation, d'un élément 5, qui présente une hauteur H de 25 à 100 mm et une surface qui a la propriété de réfléchir le rayonnement thermique émis par le monocristal vers la limite de cristallisation ou d'émettre un rayonnement thermique vers la limite de cristallisation, une modification du quotient V/G en direction radiale étant largement évitée par la disposition du bouclier thermique et de l'élément.
